# EUROPEAN PATENT APPLICATION

(11) **EP 2 693 207 A1**
(43) Date of publication of application: **05.02.2014**
(21) Application number: 12178509.1
(22) Date of filing: 30.07.2012
(51) Int. Cl.: G01N 27/22

(54) **Integrated circuit comprising a capacitive gas sensor**

(71) Applicant: NXP B.V., 5656 AG Eindhoven (NL)
(72) Inventor: Humbert, Aurelie, Redhill, Surrey RH1 1NY (GB); Gravesteijn, Dirk, Redhill, Surrey RH1 1NY (GB)
(74) Representative: Burton, Nick

(57) **Abstract**

An integrated circuit and a method of making the same. The integrated circuit includes a capacitive gas sensor (10) on a semiconductor substrate (2). The gas sensor includes first and second capacitor electrodes (4) on the substrate. The gas sensor also includes a gas sensitive material (6) having a dielectric constant that is sensitive to a gas to be detected. The gas sensitive material at least partially surrounds the capacitor electrodes and extends between the capacitor electrodes and the substrate.

## Description

### BACKGROUND OF THE INVENTION

This invention relates to an integrated circuit. In particular, this invention relates to an integrated circuit comprising a capacitive gas sensor on a semiconductor substrate.

Nowadays, integrated circuits may comprise a plethora of different sensors, such as ambient light (AL) sensors, temperature (T) sensors, gas sensors, relative humidity (RH) sensors, specific analyte detection sensors, and so on.

Integrated circuits of this kind have a wide range of applications. For example, they can be used in the field of supply chain management to track and monitor the freshness of food and beverages. They can also be used as environmental sensors, for example as part of a heating, ventilation and air conditioning (HVAC) system in an automobile or in a building (e.g. a Smart Building). Additional applications include those in agricultural (e.g. the sensing of environmental conditions in greenhouses) or in medical fields. Their provision in mobile communications devices such as mobile telephones, tablets or laptops can also enable a wide range of further applications that require measurements of local environmental factors.

The provision of sensors in integrated circuits of this kind allows devices to be produced that have a small form factor. For example, due to their small form factor, integrated circuits incorporating one or more sensors can be included in Radio Frequency Identification (RFID) tags, allowing for easy programming and readout.

Moreover, it allows large numbers of sensors to be manufactured cheaply, using established semiconductor processing techniques.

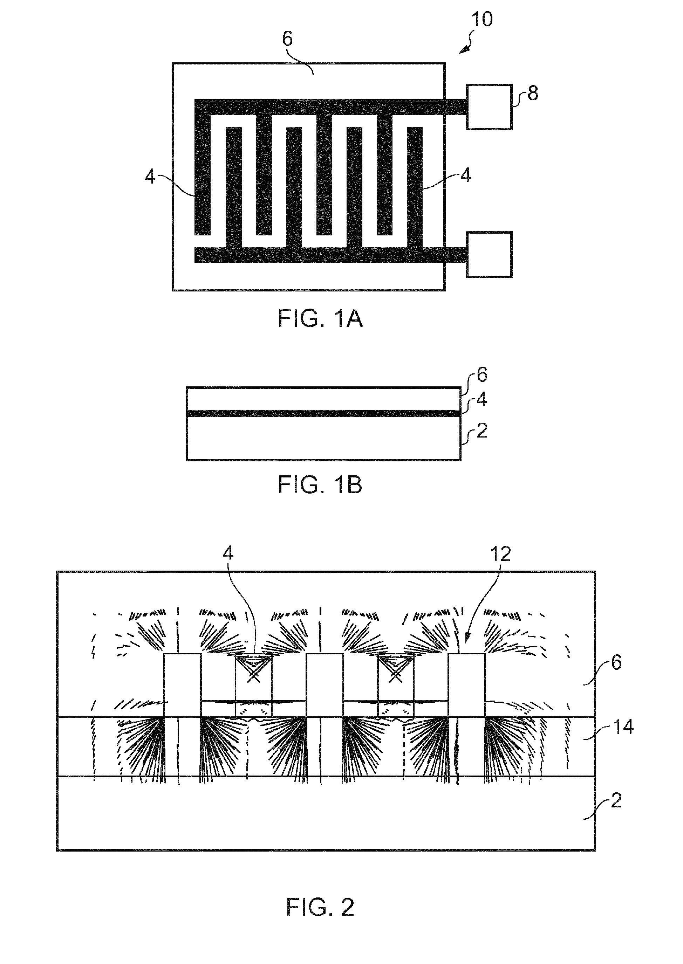

Figure 1A illustrates an example of a known kind of capacitive gas sensor 10. Figure 1B schematically illustrates a side view of the various layers included in the sensor shown in Figure 1A. The sensor includes a pair of capacitor electrodes 4 provided on a substrate 2. Bond pads 8 allow electrical connections to be made to the electrodes 4. Examples of sensors incorporating capacitor electrodes arranged in a similar manner are described in US 7,222,531, US 6,690,569, US 4,429,343 and US 6,222,376.

The sensor 10 also includes a gas sensitive layer 6. The gas sensitive layer 6 has a dielectric constant that is sensitive to a gas (e.g. CO₂) to be sensed. In operation, the dielectric constant of the gas sensitive layer 6 varies in accordance with the levels of the target gas that are present in the vicinity of the sensor. These variations in dielectric constant can be detected as changes in the capacitance of the capacitor electrodes 4. Hence, the target gas can be detected.

Figure 2 shows the results of Rafael simulations, which illustrate the extension of electric field lines between the capacitor electrodes of a gas sensor of the kind shown in Figure 1. In Figure 2, the gas sensor is shown to include interdigitated capacitor electrodes 4 on an oxide layer 14, on a substrate 2. As in Figure 1, a gas sensitive layer is provided over the electrodes 4.

From Figure 2 it can be seen that when a voltage is applied across the capacitor electrodes 4, the field lines 12 in the simulation extend above, between and below the capacitor electrodes 4. The fact that some of the field lines 12 extend outside the gas sensitive layer 6 limits the sensitivity of the sensor to the target gas. This is because the parts of the electric field outside the gas sensitive layer 6 are not affected by changes in the dielectric constant of the gas sensitive layer 6.

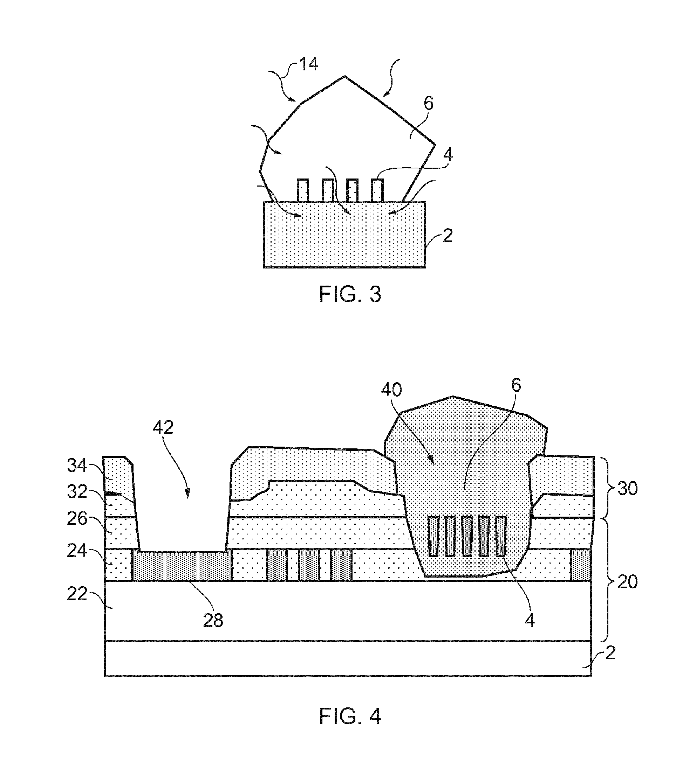

Another problem associated with sensors of this kind is that of cross sensitivity to relative humidity levels. Figure 3 illustrates the effects of relative humidity on a gas sensor of the kind described in relation to Figures 1 and 2. Again, the sensor in this example includes a substrate 2 on which are located a pair of interdigitated capacitor electrodes 4 surrounded by a gas sensitive material 6. The arrows 14 in Figure 3 indicate the entrance 14 of water molecules into the sensor and surrounding area (e.g. the substrate 2).

There are two contributions to the effect of cross sensitivity to humidity levels. Firstly, the dielectric constant of the gas sensitive material 6 itself may vary with the level of humidity. Secondly, the dielectric constant of the substrate 2 (or layers provided on the substrate) beneath the capacitor electrodes 4 may also vary with the level of humidity. The proximity of the capacitor electrodes 4 to the substrate 2 (or any layers provided thereon) can exacerbate this problem, since a significant portion of the electric field surrounding the electrodes 4 may pass through the substrate 2 (or, again, any intervening layers).

### SUMMARY OF THE INVENTION

Aspects of the invention are set out in the accompanying independent and dependent claims. Combinations of features from the dependent claims may be combined with features of the independent claims as appropriate and not merely as explicitly set out in the claims.

According to an aspect of the invention, there is provided an integrated circuit comprising a capacitive gas sensor on a semiconductor substrate. The gas sensor includes first and second capacitor electrodes on the substrate. The gas sensor also includes a gas sensitive material having a dielectric constant that is sensitive to a gas to be detected. The gas sensitive material at least partially surrounds the capacitor electrodes and extends between the capacitor electrodes and the substrate.

According to another aspect of the invention, there is provided a method of manufacturing an integrated circuit comprising a capacitive gas sensor. The method includes providing a semiconductor substrate. The method also includes forming first and second capacitor electrodes of the gas sensor on the substrate. The method further includes depositing a gas sensitive material to at least partially surround the capacitor electrodes and extend between the capacitor electrodes and the substrate. The gas sensitive material has a dielectric constant that is sensitive to a gas to be detected.

The provision of a gas sensitive material that at least partially surrounds the capacitor electrodes and that extends between the capacitor electrodes and the substrate increases the sensitivity of the sensor to a gas to be sensed, since a substantial portion of the electric field extending between the electrodes passes through the gas sensitive layer. Similarly, although in principal the sensor may still subject to issues of cross sensitivity to relative humidity associated with water molecules entering the gas sensitive layer, the cross sensitivity of the sensor associated with the presence of water in the substrate (or layers provided thereon) is reduced.

In order to allow the gas sensitive material to at least partially surround the capacitor electrodes and extend between the capacitor electrodes and the substrate, a variety of measures may be taken. In one example, the capacitor electrodes can be suspended over or within a cavity. The cavity may, for example, be created by etching away material surrounding the electrodes. After the electrodes have been released in this manner, the gas sensitive material may be deposited into the cavity created by the etching step. In some examples, the gas sensitive material can fill the cavity and may also extend some distance above the cavity.

The capacitor electrodes can be arranged within a plane parallel to a major surface of the substrate, and may also be arranged as a pair of interdigitated conductive lines.

In some embodiments, the integrated circuit may include a metallization stack. Metallization stacks of this kind are conventionally used to interconnect active components (such as transistors) located in the substrate. Integration of a gas sensor into an integrated circuit of this kind allows the sensor to be provided on a common substrate along with control circuitry for the sensor and/or further circuitry. In accordance with an embodiment of the invention, the gas sensitive material extends between the capacitor electrodes and at least some of the metallization layers of the metallization stack. This arrangement increases the sensitivity of the sensor to the target gas and reduces cross sensitivity to the presence of any water in the metallization stack for reasons analogous to those noted above.

In some embodiments, the capacitor electrodes can themselves be provided as one or more metal features of the metallization stack. For example, the capacitor electrodes can be formed in a metal level or a via level of the metallization stack. In some examples, a cavity etched into the metallization stack can allow the gas sensitive material to be deposited between the capacitor electrodes and metallization layers provided beneath the layer in which the electrodes are located.

Metallization stacks are conventionally sealed from the surrounding environment using a passivation stack including one or more passivation layers. In some embodiments, the capacitor electrodes can be located on or above the passivation stack.

The capacitor electrodes can comprise, for example, A1 or W.

According to a further aspect of the invention, there is provided a Radio Frequency Identification (RFID) tag comprising an integrated circuit of the kind described above.

According to another aspect of the invention, there is provided a mobile communications device comprising an integrated circuit of the kind described above.

According to a further aspect of the invention, there is provided a heating, ventilation and air conditioning (HVAC) system comprising one or more integrated circuits of the kind described above.

### BRIEF DESCRIPTION OF THE DRAWINGS

Embodiments of the present invention will be described hereinafter, by way of example only, with reference to the accompanying drawings in which like reference signs relate to like elements and in which:
Figures 1A and 1B show an example of a capacitive gas sensor;
Figure 2 shows the results of Rafael simulations, which illustrate the extension of electric field lines between, above and below the capacitive elements of a gas sensor of the kind shown in Figure 1;
Figure 3 illustrates the effects of relative humidity on a gas sensor of the kind described in relation to Figures 1 and 2;
Figure 4 shows an integrated circuit comprising a capacitive gas sensor in accordance with an embodiment of the invention;
Figure 5 shows another integrated circuit comprising a capacitive gas sensor in accordance with another embodiment of the invention; and
Figure 6 shows a further integrated circuit comprising a capacitive gas sensor in accordance with a further embodiment of the invention.

### DETAILED DESCRIPTION

Embodiments of the present invention are described in the following with reference to the accompanying drawings.

Embodiments of this invention can allow gas sensors to be produced having an increased sensitivity to a target gas and a reduced cross-sensitivity to relative humidity associated with water molecules entering the substrate. These improvements can be achieved by the provision of a gas sensitive material that, in addition to at least partially surrounding the capacitor electrodes of the gas sensor, extends between the capacitor electrodes and the substrate. It will be appreciated that in some examples, layers such as metallization layers or passivation layers, may also lie between the gas sensor and the substrate. In such cases, embodiments of the invention can also reduce cross-sensitivity to relative humidity associated with water molecules entering those intervening layers.

In the examples described herein, the gas sensor can be implemented on top of a metallization stack that includes a plurality of layers comprising dielectric interspersed with patterned metal features. Metallization stacks of this kind are well known in the field of integrated circuit manufacture and have the primary role of interconnecting components located on or in the semiconductor substrate of the integrated circuit. Accordingly, in some embodiments, there can be provided a semiconductor substrate including one or more active components such as transistors (for example CMOS transistors) and a metallization stack provided thereon comprising interconnects for connecting together the active components. Conveniently, the gas sensor can be provided on the metallization stack and may therefore be formed in the same backend of line process that is used to form a metallization stack itself. In such examples, the layers of the metallization stack and also one or more passivation layers provided above the stack constitute intervening layers between the gas sensor and the substrate.

In accordance with an embodiment of the invention, the principle involved in increasing the sensitivity of the gas sensor to the target gas and reducing the cross-sensitivity of the gas sensor to the effects of relative humidity is associated with the fact that the gas sensitive material extends between the capacitor electrodes of the gas sensor and the substrate. For example, the gas sensitive material can extend beneath the capacitor electrodes as described in the examples given herein below. The gas sensitive material extending between the capacitor electrodes and the substrate can ensure that the underside of the arrangement of capacitor electrodes is distanced from other features of the integrated circuit such as the substrate itself or layers located between the semiconductor substrate and the electrodes. Accordingly, the exact configuration of the substrate and any intervening layers is not considered to be essential to the principle of operation of the present invention. The provision of features such as the metallization stack noted in each of the example embodiments is therefore not considered in itself essential.

Figure 4 illustrates a first example of an integrated circuit according to an embodiment of the invention. The integrated circuit includes a substrate 2. The substrate 2 may include one or more components such as CMOS transistors or other circuitry. In this embodiment, a metallization stack 20 is provided on the substrate 2. The metallization stack 20 includes a plurality of layers. As is known in the art, these layers can include dielectric layers (e.g. silicon oxide) containing patterned metal features forming interconnects for connecting together components that are located on or in the substrate. Metallization stacks of this kind are well-known in the art and can be produced using conventional back end of line (BEOL) processing techniques.

Above the metallization stack 20, there is provided a passivation stack 30. In the present example, the passivation stack includes one or may layers of HDP (High Density Plasma) oxide 32 capped with a layer of Si₃N₄ 32. As is known in the art, passivation stacks serve to seal the metallization stack and underlying substrate from the incursion of contaminating materials such as water. The formation of the passivation stack in Figure 4 (and in subsequent examples described herein) is not essential, and in practice any suitable passivation stack configuration can be used.

In the present example, the metallization stack 20 includes a first upper layer 24 and a second upper layer 26. The first upper layer 24 of the metallization stack 20 includes a bond pad 28 for allowing electrical connection to be made to the stack 20. While only a single bond pad is illustrate here, in practice any suitable number of such bond pads 28 may be provided. In order to facilitate electrical connection to the bond pad 28, which lies beneath the upper metallization layer 26 and the passivation stack 30, an opening 42 can be formed through those layers using, for example, an etching process.

The integrated circuit also includes a capacitive gas sensor. The capacitive gas sensor includes first and second capacitor electrodes 4. In the present example, these capacitor electrodes 4 are configured as two sets of interdigitated fingers, using a configuration similar to that described above in relation to Figure 1A. Figure 4 shows this configuration in cross-section. However, it is envisaged that any suitable arrangement for the capacitor electrodes could be used. For example, while the provision of simple capacitor plates provided opposite each other in a lateral arrangement on the substrate 2 would reduce the sensitivity of the sensor owing to the reduced surface area of the plates compared to an interdigitated finger configuration, embodiments of this invention comprising such alternative capacitor electrode configurations would still exhibit increased sensitivity to the target gas and reduced cross-sensitivity to relative humidity.

As shown in Figure 4, the capacitor electrodes 4 in this example are located in the upper metallization layer 26 of the metallization stack 20. In this way, the capacitor electrodes 4 themselves may be formed from features of the metallization stack 20 and may thus conveniently be manufactured using the same back end of line processes that are used to form the metallization stack 20. In the example of Figure 4, the capacitor electrodes 4 are formed in a so called via layer of the stack. Such via layers are known in the art for vertically interconnecting laterally extending patterned metal layers of the metallization stack 20. Lower metallization layer 24 constitutes an example of such a laterally extending patterned metal layer. Typically, the laterally extending patterned metal layers may alternate with so call via layers to form the overall stack 20. In other examples, the capacitor electrodes 4 may be formed instead in one of the laterally extending patterned metal layers. In further examples, the capacitor electrodes 4 could be formed using a combination of features from more than one layer and may therefore include features from both via and laterally extending patterned metal layers.

In the example of Figure 4 the capacitor electrodes 4 are suspended in a cavity 40. This cavity may be formed by etching an opening through the passivation stack 30 and one or more layers of the metallization stack 20, thereby to expose the capacitor electrodes 4. This etching can include a degree of under-etching of the capacitor electrodes 4. The etching itself may, for example, take place during the same etching step that is used to form the opening 42 for connection to the bond pad 28.

In the present example, the integrated circuit includes a gas sensor having a gas sensitive material 6, which is located in the cavity 40. Thus, following the above described etching step of form the cavity 40, the gas sensitive material 6 can be deposited into the cavity 40, thereby substantially to surround the capacitor electrodes 4 and, because the capacitor electrodes 4 have been under-etched as noted above, to extend beneath the capacitor electrodes 4. Thus, the deposited gas sensitive material 6 extends between the capacitor electrodes 4 and the underlying substrate 2.

Typical methods for depositing the gas sensitive material in this embodiment (and indeed in all of the embodiments described herein) include known techniques such as spin coating or printing.

As can be seen in Figure 4, because the gas sensitive material 6 is situated between the capacitor electrodes 4 and the underlying features including layers of the metallization stack 20 and the substrate 2 itself, in the event that water molecules were to enter those underlying features, the effects of cross-sensitivity to those water molecules being present would be minimised. This is because the capacitance of the electrodes 4 is primarily sensitive to the immediate vicinity of the electrodes 4, which is occupied primarily with the gas sensitive material 6.

In some examples, the gas sensitive material 6 can fill the cavity 40 in which the electrodes 4 are located. However, this is not considered to be essential since it is not necessary to completely fill the cavity 40 in order to ensure that the gas sensitive material 6 at least partially surrounds and extends beneath the capacitor electrodes 4.

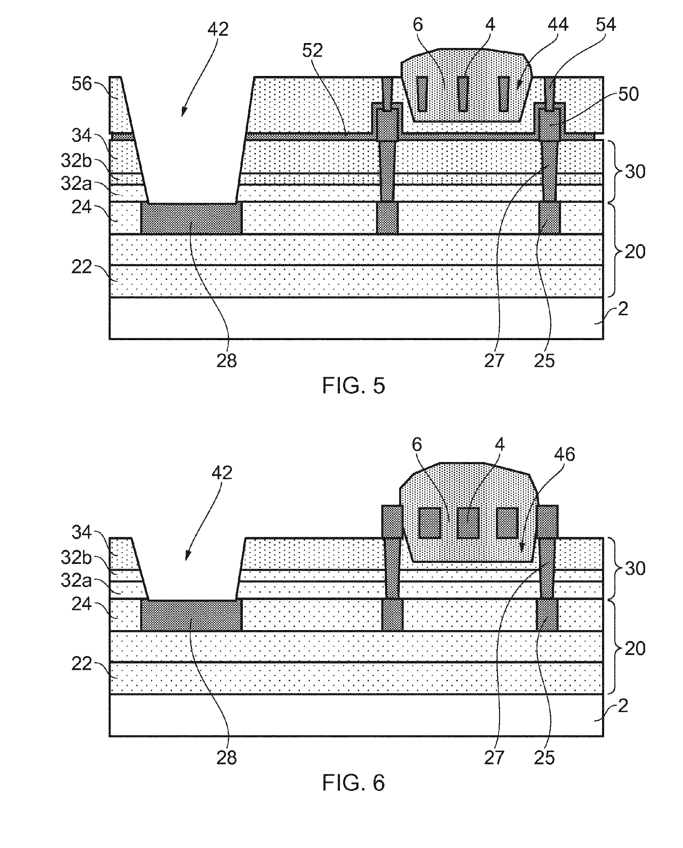

In the example of Figure 4, the capacitor electrodes 4 are provided as part of the metallization stack 20. An alternative example of an integrated circuit in accordance with an embodiment of the invention is illustrated in Figure 5.

In this example, the capacitor electrodes 4 are provided above the passivation stack 30, as will be described in more detail below.

In Figure 5, the integrated circuit includes a substrate 2 upon which there is provided a metallization stack 20. The metallization stack 20 includes a number of underlying metallization layers (including, for example, patterned metal layers extending laterally and a number of intervening via layers). The metallization stack 20 further includes a layer 24 that includes a bond pad 28. The layer 24 can also include connections 25 for connecting the terminals of the capacitor electrodes 4 to other features in the integrated circuit such as control circuitry and/or the bond pads 28.

A passivation stack 30 is located on top of the metallization stack 20. The passivation stack can include one or more layers of HDP Oxide 32a, 32b, the passivation stack 30 can also include a layer of Si₃N₄ 34 on top of the HDP Oxide layers 32a, 32b.

An opening 42 can be made in a manner analogous to that described above in relation to the example of Figure 4 through the passivation stack 30, to allow electrical connection to the bond pad or bond pads 20.

In the present example, the capacitive gas sensor includes capacitor electrodes 4 that are provided above the passivation stack 30. To implement this arrangement, a thick layer of oxide 56 can be provided above the passivation stack 30. This oxide layer can be patterned and processed to incorporate a number of further features. For example, using techniques similar to those used to form metallization layers, metal features can be incorporated into the oxide layer 56 having a shape and configuration corresponding to the capacitor electrodes 24. In the example of Figure 5, these metal features can also include terminals 54 of the capacitor electrodes 4 and, additionally, connections 50 which themselves connect to metal vias 27 that extend through the passivation stack 30 to connect to the terminals 25 in the metallization layer 24. In this way, electrical connection to the capacitor electrodes 4 of the capacitive gas sensor can be made.

Also shown in Figure 5 is the provision of a protective layer 52, which can aid in preventing corrosion of the connections 50.

As noted above, the capacitor electrodes 4 can be formed using standard metallization techniques within the thick oxide layer 56. To expose the electrodes 4, a cavity 44 can be etched into the thick oxide layer 56. Subsequently, this cavity 44 can be filled (either completely or partially) with gas sensitive material 6. When etching the oxide layer 56 to expose the capacitor electrodes 4, the etch can be controlled to at least partially under-etch the capacitor electrodes 4, thereby allowing deposition of the gas sensitive material 6 in such a way that the gas sensitive material 6 can occupy the space beneath the capacitor electrodes 4, thereby to extend between the capacitor electrodes 4 and the substrate 2.

A further embodiment of the invention is illustrated in Figure 6. In this example, the capacitor electrodes 4 of the capacitive gas sensor are provided directly on the passivation stack 20, without the need for an intervening thick oxide layer of the kind described above in relation to Figure 5.

Commonly, alternate layers of metal in metallization stacks, or in features provided outside passivation of the kind described in Figure 5, comprise different metals. For example, in Figure 5, the bond pad and terminals 25 may comprise aluminium, while the vias 27 passing through the passivation stack 20 can comprise tungsten. To continue the alternation of these layers, the terminals 50 in Figure 5 can comprise aluminium, and subsequently the capacitor electrodes 4 can comprise tungsten. Returning again to the example of Figure 6, the bond pad 28 and terminals 25 can comprise aluminium, the vias 27 can comprise tungsten and therefore the capacitor electrodes 4 can themselves comprise aluminium. These various configurations illustrate that embodiments of this invention can be made to conform with existing semiconductor manufacturing design rules, thereby allowing costs to be minimised.

In the example of Figure 6, a cavity 46 can be etched into the passivation stack 20 beneath the capacitor electrodes. In principle, this cavity 46 can be made deep enough to pass through any number of layers within the stack 20.The formation of the cavity 46 can be followed by the deposition of a gas sensitive material 6. In common with the examples described above, the gas sensitive layer 6 can be seen in Figure 6 to extend beneath the capacitor electrodes 4, thereby to extend between the capacitor electrodes 4 and the substrate 2.

Since the cavity 46 extends beneath the capacitor electrodes 4, in the present example, the capacitor electrodes 4 are suspended over the cavity 46. In other examples, the capacitor electrodes 4 may sit slightly or even completely within the cavity 46 formed in the passivation stack 30.

An integrated circuit of the kind described herein, can, for example, be incorporated into a radio frequency identification (RFID) tag. The sensor can be connected to circuitry of the RFID tag, including features such as an antenna to allow readout of sensing data collected by the sensor. Similarly, an integrated circuit of the kind described herein, may be incorporated into a mobile communications device such as a laptop, tablet or mobile telephone to allow the device to collect data relating to the presence of a target gas and use the data for various applications.

It is further envisaged that an integrated circuit of the kind described herein, could be incorporated into a heating, ventilation and air conditioning (HVAC) system. This would allow the HVAC system to collect information relating to the presence of one or more target gasses in the heating, ventilation or air conditioning of, for example, a building (for example a greenhouse or office building), or a vehicle such as an automobile or an aircraft.

The integrated circuit described herein may be used to detect the presence of one or more target gasses. The choice of gas sensitive material 6 in the embodiments described herein can be made in accordance with the target gas to be detected. Table 1 below indicates a range of target gases and the gas sensitive materials that can be used.

**Table 1: Target Gases and Gas Sensitive Materials**

| Target Gas | Gas Sensitive Material |
|---|---|
| Humidity | Al₂O₃, polyimide, TiO₂, SiO₂, SiC, polyesters, PMMA (Polymethyl methacrylate), BCB (Benzocyclobutene), polysulfates, cellulose acetate butyrate, porous silicon |
| CO₂ | Fluoropolymer, CuO mixed with BaSnO₃, SrTiO₃, CaTiO₃, ZnO or BaTiO₃, N-H containing polymers |
| O₂ | Zirconium oxide, Irridium oxides |
| Ethylene | SnO₂ based film |
| NH₃ | Porous SiC, TiO₂ |

Further examples of suitable sensitive materials can be found in, for example, Table 2 of "Materials Used as Chemical Sensor Elements" in "Chemical Sensor Technology", Vol.1, Ed. Tetsuro Seiyama, Elsevier 1988.

With reference to Table 1, it is noted that in the case of "humidity", the target gas comprises a gas of individual water molecules. These molecules may, for example, be carried in air. These water molecules do not constitute water vapour as such, since they are not condensed into droplets of water.

Embodiments of the present invention comprising humidity sensors can benefit from the provision of a gas sensitive material (e.g. of the kind mentioned in Table 1) that at least partially surrounds the capacitor electrodes and that extends between the capacitor electrodes and the substrate since, as described herein, a substantial portion of the electric field extending between the electrodes passes through the gas sensitive layer. Moreover, while sensitivity to water molecules entering the gas sensitive layer is actually desired for correct operation of the humidity sensor, in common with other embodiments, cross sensitivity of the sensor associated with the presence of water in the substrate (or layers provided thereon) is reduced.

Accordingly, there has been described an integrated circuit and a method of making the same. The integrated circuit includes a capacitive gas sensor on a semiconductor substrate. The gas sensor includes first and second capacitor electrodes on the substrate. The gas sensor also includes a gas sensitive material having a dielectric constant that is sensitive to a gas to be detected. The gas sensitive material at least partially surrounds the capacitor electrodes and extends between the capacitor electrodes and the substrate.

Although particular embodiments of the invention have been described, it will be appreciated that many modifications/additions and/or substitutions may be made within the scope of the claimed invention.

## Claims

1. An integrated circuit comprising a capacitive gas sensor on a semiconductor substrate, the gas sensor comprising:
first and second capacitor electrodes on the substrate; and
a gas sensitive material having a dielectric constant that is sensitive to a gas to be detected, wherein the gas sensitive material at least partially surrounds the capacitor electrodes and extends between the capacitor electrodes and the substrate.

2. The integrated circuit of claim 1, wherein the capacitor electrodes are suspended over or within a cavity.

3. The integrated circuit of claim 2, wherein the gas sensitive material fills the cavity.

4. The integrated circuit of any preceding claim, wherein the capacitor electrodes are arranged within a plane parallel to a major surface of the substrate.

5. The integrated circuit of claim 4, wherein the first and second capacitor electrodes are arranged as a pair of interdigitated conductive lines.

6. The integrated circuit of any preceding claim, further comprising a metallization stack comprising a plurality of metallization layers, wherein the gas sensitive material extends between the capacitor electrodes and at least some of the metallization layers.

7. The integrated circuit of claim 6, wherein the capacitor electrodes are comprised of one or more metal features of the metallization stack.

8. The integrated circuit of claim 7, wherein the capacitor electrodes are formed in a metal level or a via level of the metallization stack.

9. The integrated circuit of any preceding claim, wherein the capacitor electrodes are located on a passivation stack on the substrate.

10. The integrated circuit of any preceding claim, wherein the capacitor electrodes comprise A1 or W.

11. A Radio Frequency Identification (RFID) tag comprising the integrated circuit of any preceding claim.

12. A mobile communications device comprising the integrated circuit of any of claims 1 to 10.

13. A heating, ventilation and air conditioning (HVAC) system comprising one or more integrated circuits according to any of claims 1 to 10.

14. A method of manufacturing an integrated circuit comprising a capacitive gas sensor, the method comprising:
providing a semiconductor substrate;
forming first and second capacitor electrodes of the gas sensor on the substrate; and
depositing a gas sensitive material to at least partially surround the capacitor electrodes and extend between the capacitor electrodes and the substrate, wherein the gas sensitive material has a dielectric constant that is sensitive to a gas to be detected.
